# DEMANDE DE BREVET EUROPEEN

(11) **EP 1 672 967 A1**
(43) Date de publication de la demande: **21.06.2006**
(21) Numéro de dépôt: 04405782.6
(22) Date de dépôt: 17.12.2004
(51) Int. Cl.: H05K 1/02, G01N 27/00, G01N 27/447, A61B 5/00, G05D 7/00, G05D 7/06

(54) **Procédé de réalisation d'un dispositif volumique miniaturisé**

(71) Demandeur: Valtronic S.A., 1343 Les Charbonnières (CH)
(72) Inventeur: Rochat, Michel, 1167 Lussy s/Morges (CH); Lemaire, Lionel, 1168 Villars sous Yens (CH)
(74) Mandataire: GLN

(57) **Abrégé**

L'invention concerne un procédé de fabrication d'un dispositif volumique hétérogène miniaturisé comportant au moins un composant et sa connexion intégrés au sein d'une matrice de soutien. Cette matrice est formée par une technique de dépôt consistant à apporter, par passages successifs, de la matière sous forme fluide aux emplacements où elle est nécessaire de manière à constituer progressivement la matrice.

## Description

La présente invention se rapporte au domaine de l'assemblage de composants microtechniques. Elle concerne, plus précisément, un procédé de fabrication d'un dispositif volumique miniaturisé, à fonction électrique et/ou optique et/ou fluidique, c'est à dire hétérogène. L'invention concerne également le dispositif ainsi obtenu.

L'invention trouve une application particulièrement intéressante dans la fabrication de dispositifs destinés à des analyses de type chimique ou biologique tels que décrits, par exemple, dans le document WO 03/035386. De tels dispositifs hétérogènes miniaturisés sont conçus pour une utilisation unique ou multiple, et employés, par exemple, pour le diagnostic médical ou l'implantation dans le corps humain.

Dans le domaine de la microtechnique, la plupart des technologies d'assemblage visent à réunir et interconnecter sur un même substrat le plus grand nombre possible de composants, au moindre coût et en minimisant l'encombrement final.

La densification des composants s'est faite initialement dans le plan. Actuellement, elle se fait de plus en plus dans le volume, c'est-à-dire par empilement des composants.

Une méthode consiste à assembler les composants sur un substrat flexible initialement plat puis, par pliage, à former un empilement et obtenir un module de forme généralement parallélépipédique. Une autre méthode consiste à empiler des substrats rigides dotés de métallisations sur la tranche afin d'obtenir des connexions entres les différentes couches, puis à les laminer pour former un ensemble monolithique.

Ces technologies sont toutefois limitées par la largeur minimale des pistes conductrices (actuellement de l'ordre de 100 microns) qui s'oppose à la densification croissante des dispositifs. Par ailleurs, la fabrication des substrats et l'assemblage des composants constituent deux opérations distinctes, ce qui pose un certain nombre de problèmes pour l'approvisionnement et la logistique.

Il faut enfin remarquer que ces procédés sont peu adaptés à l'intégration d'éléments de type optique ou fluidique, tels que des guides d'ondes, des micro-spectromètres optiques ou des canaux micro-fluidiques. Or, ces éléments, combinés à des composants électroniques, prennent une part croissante au sein de dispositifs complexes hétérogènes et, notamment pour les applications médicales et bio-médicales.

Un exemple d'approche existant déjà en vue de fabriquer ces dispositifs hétérogènes, est le procédé 'PCB'.

L'approche 'PCB', telle que décrite dans le document déjà cité, fait appel à la technologie des circuits imprimés pour fabriquer, sur des substrats bon marché, des dispositifs complexes intégrant des éléments optiques ou fluidiques aussi bien que des composants électroniques. Néanmoins, cette technologie est relativement lourde et complexe puisqu'elle met en oeuvre de nombreuses étapes de dépôt de résine ou de cuivre alternant avec des étapes de photo-lithographie, de gravure ou de perçage, nécessitant un savoir-faire et des équipements très spécifiques.

La présente invention a pour but de proposer une technologie simple, compacte et originale de fabrication de dispositifs hétérogènes volumiques, permettant de s'affranchir totalement des procédés employés dans les technologies des circuits imprimés.

Plus précisément, l'invention concerne un procédé de fabrication d'un dispositif volumique hétérogène miniaturisé comportant au moins un composant et sa connexion intégrés au sein d'une matrice de soutien. Ce procédé est caractérisé en ce que la matrice est formée par une technique de dépôt consistant à apporter, par passages successifs, de la matière sous forme fluide aux emplacements où elle est nécessaire de manière à constituer progressivement la matrice.

De façon avantageuse, ledit composant ou ladite connexion peut être :
- soit intégré à la matrice en cours de fabrication, à l'aide d'une technique d'assemblage standard, en un emplacement laissé vide de matière et réservé à cet effet ;
- soit formé directement, au sein de la matrice, par ladite technique de dépôt ;
- soit formé, au sein de la matrice, par une étape de dépôt de substance sacrificielle utilisant ladite technique de dépôt, suivie d'une étape d'élimination de cette substance.

L'invention concerne également un dispositif volumique hétérogène du type comportant au moins un composant et une connexion intégrés au sein d'une matrice de soutien. Ce dispositif est caractérisé en ce que la matrice est de type monobloc.

D'autres caractéristiques de l'invention ressortiront de la description qui va suivre, faite en regard du dessin annexé dans lequel :
- la figure 1 représente une vue en perspective d'un dispositif hétérogène;
- la figure 2 est une vue stratifiée de ce même dispositif sur un substrat porteur; et
- la figure 3 est une vue en coupe selon l'axe AA du dispositif de la figure 1.

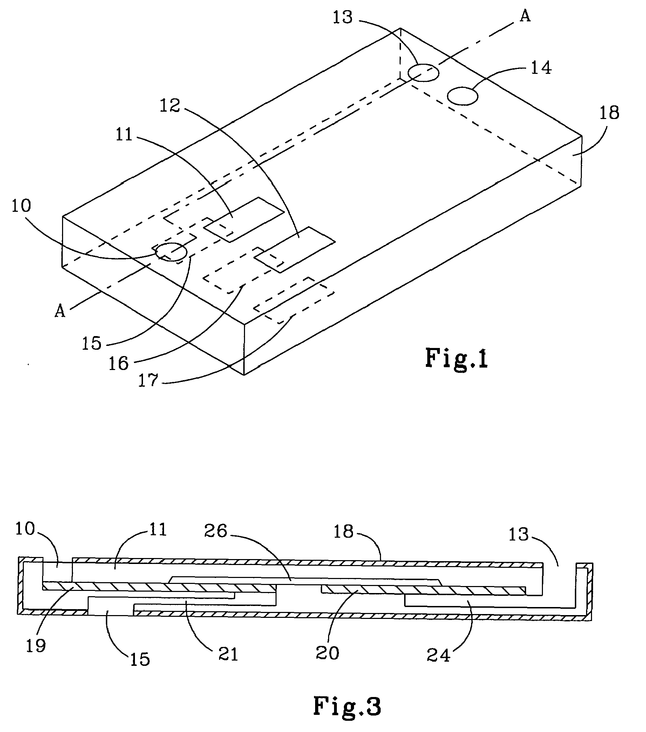

Le dispositif hétérogène représenté sur la figure 1 est un exemple de dispositif comprenant des composants intégrés dans le volume, connectés entre eux et accessibles, depuis la surface, grâce à des connexions électriques, optiques et fluidiques. Ces composants peuvent être, par exemple, des composants simples, c'est à dire soit électriques, soit optiques, soit fluidiques, tels que des éléments résistifs, des réseaux optiques ou des chambres destinées à mélanger des fluides. Ils peuvent être également des composants complexes de type, par exemple, optoélectronique tels que des modulateurs optiques, opto-fluido-électronique tels que des micro-spectromètres optiques, ou encore fluido-électronique. Les connexions destinées à transporter un signal électrique ou optique, ou de la matière sous forme fluide, sont typiquement des pistes électriques, des segments transparents ou des guides d'ondes, ou encore des canaux horizontaux ou verticaux.

Le dispositif représenté sur la figure 1, de forme rectangulaire, de dimensions typiquement 20x10mm comporte, en sa face supérieure, une entrée optique 10, deux connexions électriques 11 et 12, ainsi qu'une entrée et une sortie fluidiques, respectivement 13 et 14, destinées à la circulation d'un fluide à analyser. Il comporte également en sa face inférieure trois connexions électriques 15, 16 et 17. Si ce dispositif est destiné à être implanté dans le corps, il est enfermé dans une enveloppe 18 constituée d'un matériau biocompatible bien toléré par l'organisme humain.

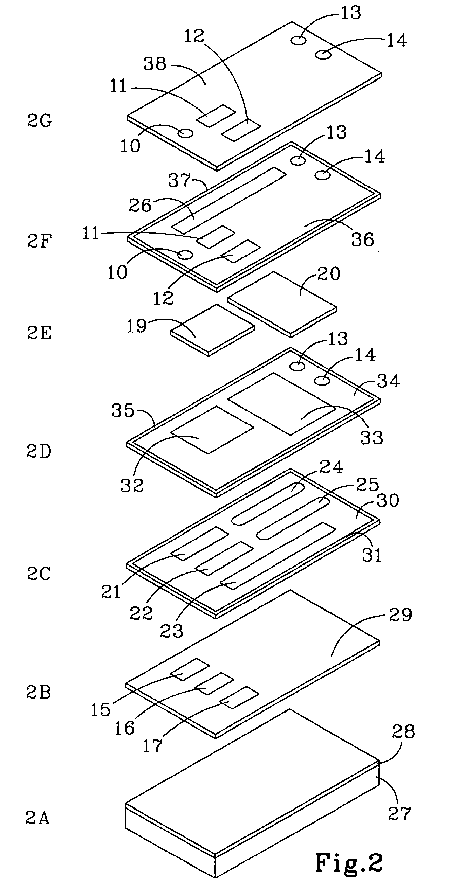

La vue stratifiée du dispositif, représentée sur la figure 2, permet d'en comprendre la structure et son procédé de fabrication. Il comporte, dans son volume, deux composants 19 et 20 et leurs connexions, ces différents éléments étant intégrés au sein d'une matrice de soutien monobloc assurant le rôle de substrat à trois dimensions. Le composant 19 est de type optoélectronique, ses connexions étant de type optique et électrique. Le composant 20 est de type opto-fluido-électronique, ses connexions étant de type optique, électrique et fluidique.

A l'intérieur du volume, trois pistes conductrices 21, 22 et 23, deux canaux fluidiques 24 et 25, et un guide d'onde 26 sont destinés à interconnecter les composants. Ces divers éléments sont, en outre, reliés à l'extérieur par l'intermédiaire des deux contacts électriques supérieurs 11 et 12, des trois contacts électriques inférieurs 15, 16 et 17, des deux connexions fluidiques 13 et 14, et de la connexion optique 10.

Les pistes électriques 21 et 22 relient le composant 19 aux contacts électriques inférieurs 15 et 16, respectivement. La piste électrique 23 relie, de la même façon, le composant 20 et le contact électrique inférieur 17. Les contacts électriques supérieurs 11 et 12 connectent le composant 19. L'entrée optique 10 assure la liaison optique entre le composant 19 et l'extérieur, tandis que les entrée et sortie fluidiques 13 et 14 sont reliées respectivement aux canaux fluidiques 24 et 25. Ces derniers viennent au contact du composant 20 et permettent de faire circuler le fluide à analyser à travers ce composant. Enfin, le guide d'onde 26 fait office de liaison optique entre les composants 19 et 20, le composant 20 n'étant pas directement relié à l'entrée optique 10.

La technologie utilisée pour fabriquer ce dispositif hétérogène volumique est de type additive. Elle consiste, d'une part, à déposer une quantité d'un matériau choisi à l'endroit où il est utile, pour constituer les zones pleines, telles que la matrice, le guide d'onde ou les pistes électriques et, d'autre part, à déposer un matériau sacrificiel éliminé lors d'une étape ultérieure, pour constituer les zones vides, telles que les canaux fluidiques.

Les différentes méthodes de dépôt de type à écriture ou impression directe sont, par exemple, l'impression à jet d'encre, plus connue sous la désignation 'inkjet printing', telle que décrite dans le document WO02/47447A1, la micro-distribution, plus connue sous la désignation 'micro-dispensing', ou l'impression laser, plus connue sous la désignation 'laser direct writing'.

L'impression à jet d'encre consiste à projeter sur un substrat, de façon contrôlée, avec une grande précision et à l'aide de buses d'un diamètre très faible (inférieur à 50 microns), de fines gouttelettes d'un matériau à déposer. Des systèmes à plusieurs têtes ou à têtes multiples permettent de distribuer différents matériaux. La micro-distribution utilise une micro-pipette ou un capillaire se déplaçant au voisinage d'un substrat, afin de déposer de la matière sous forme liquide. Enfin, l'impression laser permet de vaporiser un solide au voisinage d'un substrat où il va se déposer.

Les matériaux utilisés peuvent être des polyimides pour les parties non conductrices, des polymères conducteurs ou des encres conductrices pour les parties électriquement conductrices, des polymères de qualité optique pour les guides d'ondes, et des matériaux sacrificiels pour les canaux micro-fluidiques.

La matière est déposée par passages successifs sur un substrat porteur possédant une couche sacrificielle dont l'élimination permettra, au terme du procédé, de séparer le dispositif du substrat. Les couches, qui ont typiquement une épaisseur de 1 à 500 microns, se superposent les unes aux autres, créant ainsi le volume du dispositif. Les différents éléments présents dans le dispositif sont soit directement fabriqués par écriture directe, soit intégrés au dispositif, en cours de dépôt, par un procédé d'assemblage standard.

La vue stratifiée du dispositif hétérogène représentée sur la figure 2, illustre un exemple de séquence de fabrication d'un tel dispositif.

### Figure 2A

La première étape de fabrication consiste à se doter d'un substrat porteur 27 recouvert d'une couche sacrificielle 28, telle que de l'aluminium. Le substrat peut être, par exemple, une plaquette circulaire de silicium ou de verre de diamètre 20cm, sur laquelle sont fabriqués plusieurs dispositifs simultanément.

### Figure 2B

Une couche 29, d'épaisseur environ 20 microns, réalisée en un polymère biocompatible destiné à former l'enveloppe 18 du dispositif, ainsi que les trois contacts électriques 15, 16, 17, sont déposés, par écriture directe, sur la couche sacrificielle 28. Un polymère conducteur ou une encre conductrice, est utilisé pour la fabrication des contacts électriques.

### Figure 2C

Une troisième étape consiste à déposer, par écriture directe, les pistes conductrices 21, 22 et 23 et à former les canaux fluidiques 24 et 25 au sein de la matrice de soutien. Pour ce faire, une couche de matrice de soutien 30 en polyimide est déposée, par écriture directe, en même temps que les pistes conductrices 21, 22 et 23. Les canaux fluidiques 24 et 25, qui sont des espaces horizontaux vides de matière, sont formés par dépôt d'un matériau sacrificiel à leur endroit. Ce matériau sera éliminé lors d'une étape ultérieure du procédé de fabrication. Une couche 31 d'un polymère biocompatible, destinée à former l'enveloppe 18 du dispositif, est également déposée tout autour de la couche de matrice de soutien 30, sur une largeur de 50 à 100 microns.

### Figure 2D

Des emplacements 32 et 33 destinés à recevoir les composants 19 et 20 sont formés et les connexions fluidiques 13 et 14 sont amorcées. Pour cela, une couche de matrice de soutien 34, d'épaisseur correspondant à l'épaisseur des composants 19 et 20, soit 100 à 500 microns, est déposée par écriture directe sur toute la surface excepté aux emplacements 32 et 33 réservés aux composants. Un polymère sacrificiel est, de la même façon, déposé en deux espaces circulaires débouchant sur les canaux fluidiques 24 et 25, afin de former les connexions fluidiques 13 et 14. Comme pour l'étape précédente, une couche 35 d'un polymère biocompatible, destinée à former l'enveloppe du dispositif, est déposée tout autour de la couche de soutien 34, sur une largeur de 50 à 100 microns.

### Figure 2E

Les composants 19 et 20 sont disposés dans les ouvertures 32 et 33 à l'aide d'une technologie d'assemblage standard.

### Figure 2F

Une couche de matrice de soutien 36 est déposée par écriture directe, en même temps que les contacts électriques 11 et 12, le guide d'onde 26 et l'entrée optique 10. Ces deux dernières connexions sont constituées d'un polymère de qualité optique, dont l'indice de réfraction est différent de l'indice de la matrice de soutien. Un polymère sacrificiel est déposé à l'emplacement des connexions fluidiques 13 et 14. Comme auparavant, une couche 37 d'un polymère biocompatible est déposée tout autour de la couche de soutien 36.

A ce niveau de fabrication du dispositif, il est nécessaire d'éliminer le matériau sacrificiel, typiquement du poly-propylène-carbonate (PPC) ou du polyéthylène-carbonate (PEC), formant les canaux fluidiques 24 et 25 ainsi que les connexions fluidiques 13 et 14. L'élimination de ce matériau se fait généralement par pyrolyse, ce qui permet une décomposition thermique totale sans aucun résidu. Après disparition du matériau sacrificiel, les canaux et les connexions fluidiques apparaissent comme des espaces vides au sein de la matrice de soutien.

### Figure 2G

Dans une septième étape, une couche 38, d'épaisseur environ 20 microns, d'un polymère biocompatible destiné à former l'enveloppe 18 du dispositif, est déposée par écriture directe. Seuls les emplacements des connexions fluidiques 13 et 14, optique 10 et des contacts électriques 11 et 12 sont laissés libres de matière.

Enfin, une dernière opération consiste à éliminer la couche sacrificielle 28 afin de désolidariser le dispositif de son support mécanique 27. Cette opération est réalisée, par exemple, par dissolution anodique de l'aluminium.

La figure 3 montre, en coupe, le dispositif monobloc finalement obtenu.

La séquence de fabrication ainsi présentée donne un mode de réalisation par écriture directe du dispositif hétérogène représenté en figure 1 et 2. Dans ce mode de réalisation, les connexions telles que les pistes électriques, les canaux fluidiques, le guide d'onde ou l'entrée optique, sont fabriqués directement au sein de la matrice, par écriture directe. Il serait pourtant concevable d'utiliser des éléments rapportés pour constituer ces connexions et de les intégrer au sein de la matrice par un procédé d'assemblage standard. Les connexions électriques pourraient être de simples rubans métalliques, les canaux fluidiques des tubes creux, et les connexions optiques des éléments d'un matériau transparent ou ayant un indice de réfraction déterminé.

De la même manière, dans le mode de réalisation présenté, les composants 19 et 20 intégrés au dispositif sont des composants complexes disposés dans la matrice par un procédé d'assemblage standard, et ne pouvant pas être formés par écriture directe. Il serait pourtant possible de former dans la matrice, par écriture directe, des composants simples tels que des éléments résistifs, des réseaux optiques ou des chambres fluidiques, voire des composants plus complexes de type circuits intégrés à base de matériaux polymères.

Ainsi, une grande partie des éléments intégrés à la matrice et formant la partie active du dispositif monobloc peuvent être soit fabriqués par écriture directe, soit disposés à l'intérieur de la matrice par un procédé d'assemblage standard.

Ainsi est proposé un procédé de fabrication de dispositifs hétérogènes compacts monoblocs constitués d'une matrice et de différents éléments, permettant, grâce à l'utilisation d'une technique de dépôt de type à écriture directe :
- de former une matrice monobloc à trois dimensions assurant la rigidité du dispositif et la protection desdits éléments;
- d'intégrer au sein de cette matrice des composants électriques et/ou optiques et/ou fluidiques;
- d'assurer la connexion entre eux ou vers l'extérieur de ces différents composants grâce à l'intégration, dans la matrice, de connexions optiques, fluidiques ou électriques.

Cette technique est particulièrement avantageuse puisqu'elle permet, en outre, de s'affranchir totalement des séquences de dépôt / masquage / gravure indispensables dans la technologie PCB.

## Revendications

1. Procédé de fabrication d'un dispositif volumique hétérogène miniaturisé comportant au moins un composant (19, 20) et sa connexion (10, 11, 12, 13, 14, 15, 16, 17, 21, 22, 23, 24, 25, 26) intégrés au sein d'une matrice de soutien (30, 34, 36), **caractérisé en ce que** ladite matrice (30, 34, 36) est formée par une technique de dépôt consistant à apporter, par passages successifs, de la matière sous forme fluide aux emplacements où elle est nécessaire de manière à constituer progressivement la matrice (30, 34, 36).

2. Procédé selon la revendication 1, **caractérisé en ce que** ledit composant (19, 20) est intégré à la matrice (30, 34, 36) en cours de fabrication, à l'aide d'une technique d'assemblage standard, en un emplacement laissé vide de matière (32, 33) et réservé à cet effet.

3. Procédé selon la revendication 1, **caractérisé en ce que** ledit composant est formé directement, au sein de la matrice (30, 34, 36), par ladite technique de dépôt de matière.

4. Procédé selon la revendication 1, **caractérisé en ce que** ledit composant est formé, au sein de la matrice (30, 34, 36), par une étape de dépôt de substance sacrificielle utilisant ladite technique de dépôt, suivie d'une étape d'élimination de cette substance.

5. Procédé selon l'une des revendications 1 à 4, **caractérisé en ce que** ladite connexion est intégrée à la matrice (30, 34, 36) en cours de fabrication, à l'aide d'une technique d'assemblage standard, en un emplacement laissé vide de matière et réservé à cet effet.

6. Procédé selon l'une des revendications 1 à 4, **caractérisé en ce que** ladite connexion (10, 11, 12, 15, 16, 17, 21, 22, 23, 26) est formée, au sein de la matrice (30, 34, 36), par ladite technique de dépôt de matière.

7. Procédé selon l'une des revendications 1 à 4, **caractérisé en ce que** ladite connexion (13, 14, 24, 25) est formée, au sein de la matrice (30, 34, 36) par une étape de dépôt de substance sacrificielle utilisant ladite technique de dépôt, suivie d'une étape d'élimination de cette substance.

8. Procédé selon l'une des revendications 1 à 7, **caractérisé en ce que** la matière constituant ladite matrice (30, 34, 36) est un polymère non conducteur.

9. Procédé selon l'une des revendications 3 et 6, **caractérisé en ce que** la matière constituant ladite connexion (11, 12, 15, 16, 17, 21, 22, 23) ou ledit composant est un polymère conducteur.

10. Procédé selon l'une des revendications 3 et 6, **caractérisé en ce que** la matière constituant ladite connexion (11, 12, 15, 16, 17, 21, 22, 23) ou ledit composant est une encre conductrice.

11. Procédé selon l'une des revendications 3 et 6, **caractérisé en ce que** la matière constituant ladite connexion (10, 26) ou ledit composant est un polymère optique.

12. Procédé selon l'une des revendications 4 et 7, **caractérisé en ce que** ladite substance sacrificielle est un polycarbonate.

13. Procédé selon l'une des revendications 1 à 12, **caractérisé en ce que** ladite technique de dépôt est l'impression à jet d'encre.

14. Procédé selon l'une des revendications 1 à 12, **caractérisé en ce que** ladite technique de dépôt est l'impression laser par vaporisation d'un matériau solide.

15. Procédé selon l'une des revendications 1 à 12, **caractérisé en ce que** ladite technique de dépôt est la micro-distribution.

16. Procédé selon l'une des revendications 1 à 15, **caractérisé en ce que** ladite matière est déposée sur un substrat porteur (27) recouvert d'une couche de substance sacrificielle (28) dont l'élimination permet de séparer le dispositif dudit substrat (27).

17. Dispositif volumique hétérogène comportant au moins un composant (19, 20) et une connexion (10, 11, 12, 13, 14, 15, 16, 17, 21, 22, 23, 24, 25, 26) intégrés au sein d'une matrice de soutien (30, 34, 36), **caractérisé en ce que** ladite matrice (30, 34, 36) est de type monobloc.

18. Dispositif selon la revendication 17 **caractérisé, en ce que** ladite matrice de soutien (30, 34, 36) est en polymère non conducteur.

19. Dispositif selon l'une des revendications 17 et 18, **caractérisé en ce que** ledit composant est de type électrique.

20. Dispositif selon l'une des revendications 17 et 18, **caractérisé en ce que** ledit composant est de type optique.

21. Dispositif selon l'une des revendications 17 et 18, **caractérisé en ce que** ledit composant est de type fluidique.

22. Dispositif selon l'une des revendications 17 à 21, **caractérisé en ce que** ladite connexion (11, 12, 15, 16, 17, 21, 22, 23) est électrique.

23. Dispositif selon l'une des revendications 17 à 21, **caractérisé en ce que** ladite connexion (10, 26) est optique.

24. Dispositif selon l'une des revendications 17 à 21, **caractérisé en ce que** ladite connexion (13, 14, 24, 25) est fluidique.

25. Dispositif selon l'une des revendications 17 à 24, **caractérisé en ce que** ledit dispositif possède une enveloppe extérieure (18, 29, 31, 35, 37, 38) en matériau bio-compatible.
